(19) Europäisches Patentamt

European Patent Office

Office européen des brevets

(11) **EP 4 528 883 A1**

(12) **EUROPEAN PATENT APPLICATION**

(43) Date of publication:
26.03.2025 Bulletin 2025/13

(21) Application number: 23198845.2

(22) Date of filing: 21.09.2023

(51) International Patent Classification (IPC):
$H01M\ 10/48^{(2006.01)}$    $H01M\ 10/42^{(2006.01)}$
$H01M\ 50/249^{(2021.01)}$    $H01M\ 10/613^{(2014.01)}$
$H01M\ 10/625^{(2014.01)}$    $H01M\ 10/6554^{(2014.01)}$
$H01M\ 50/204^{(2021.01)}$    $H01M\ 50/224^{(2021.01)}$
$H01M\ 50/284^{(2021.01)}$    $H01M\ 50/569^{(2021.01)}$
$H01M\ 50/572^{(2021.01)}$

(52) Cooperative Patent Classification (CPC):
H01M 10/48; H01M 10/425; H01M 10/4264;
H01M 10/4285; H01M 10/488; H01M 10/613;
H01M 10/625; H01M 10/6554; H01M 50/204;
H01M 50/224; H01M 50/249; H01M 50/284;
H01M 50/569; H01M 50/572; H01M 2010/4278;
(Cont.)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Samsung SDI Co., Ltd
Gyeonggi-do 17084 (KR)**

(72) Inventor: **Maxl, Florian
8020 Graz (AT)**

(74) Representative: **Gulde & Partner
Patent- und Rechtsanwaltskanzlei mbB
Berliner Freiheit 2
10785 Berlin (DE)**

(54) **HOUSING FOR A BATTERY SYSTEM, BATTERY SYSTEM, ELECTRIC VEHICLE AND METHOD FOR DETECTING DAMAGES OF THE HOUSING**

(57) The present disclosure refers to a housing (10, 10') for a battery system (100). The housing (10, 10') includes an underbody structure (12) and a detection system (14) for detecting damages of the underbody structure (12). The underbody structure (12) includes an upper portion (16) and a lower portion (18) which are electrically conductive and oppositely arranged at a distance (d) from each other to be electrically isolated from each other such that a capacitor (C) is formed and the detection system (14) includes a resonant circuit (20) into which the capacitor (C) is interconnected. The detection system (14) is configured to apply a voltage to the resonant circuit (20) at the resonance frequency of the resonant circuit (20) and to detect the change of the capacitance by monitoring a change of the current at the resonance frequency.

FIG. 1

**(Cont. next page)**

(52) Cooperative Patent Classification (CPC): (Cont.)
H01M 2220/20

## Description

### Field of the Disclosure

The present disclosure relates to a housing for a battery system, a battery system including the housing, an electric vehicle including the battery system and a method for detecting damages of an underbody structure of a housing for a battery system.

### Technological Background

Recently, vehicles for transportation of goods and peoples have been developed that use electric power as a source for motion. Such an electric vehicle is an automobile that is propelled by an electric motor, using energy stored in rechargeable batteries. An electric vehicle may be solely powered by batteries or may be a form of hybrid vehicle powered by for example a gasoline generator or a hydrogen fuel power cell. A hybrid vehicle may include a combination of an electric motor and conventional combustion engine. Generally, an electric-vehicle battery, EVB, or traction battery is a battery used to power the propulsion of battery electric vehicles, BEVs. Electric-vehicle batteries differ from starting, lighting, and ignition batteries in that they are designed to provide power for sustained periods of time. A rechargeable (or secondary) battery differs from a primary battery in that it is designed to be repeatedly charged and discharged, while the latter is designed to provide only an irreversible conversion of chemical to electrical energy. Low-capacity rechargeable batteries are used as power supplies for small electronic devices, such as cellular phones, notebook computers and camcorders, while high-capacity rechargeable batteries are used as power supplies for electric and hybrid vehicles and the like.

Rechargeable batteries may be used as a battery module formed of a plurality of unit battery cells coupled to each other in series and/or in parallel so as to provide a high density such as for motor driving of a hybrid vehicle. For example, the battery module may be formed by interconnecting the electrode terminals of the plurality of unit battery cells in an arrangement or configuration depending on a desired amount of power and in order to realize a high-power rechargeable battery.

Battery modules can be constructed in either a block design or in a modular design. In the block design each battery is coupled to a common current collector structure and a common battery management system and the unit thereof is arranged in a housing. In the modular design, pluralities of battery cells are connected together to form submodules and several submodules are connected together to form the battery module. In automotive applications, battery systems generally include of a plurality of battery modules connected in series for providing a desired voltage. The battery modules may include submodules with a plurality of stacked battery cells and each stack includes cells connected in parallel that are, in turn, connected in series ($XpYs$) or cells connected in series that are, in turn, connected in parallel ($XsYp$).

Mechanical integration of such a battery pack incorporates suitable mechanical connections between the individual components of, for example, battery modules, and between them and a supporting structure of the vehicle. These connections are designed to remain functional and save throughout the average service life of the battery system. Further, installation space and interchangeability standards must be met, especially in mobile applications.

Mechanical integration of battery modules may be achieved by providing a carrier framework and by positioning the battery modules thereon. Fixing the battery cells or battery modules may be achieved by using fitted depressions in the framework or by mechanical interconnectors, such as bolts or screws. In other examples, the battery modules are confined by fastening side plates to lateral sides of the carrier framework. Moreover, cover plates may be fixed atop and below the battery modules.

The carrier framework of the battery pack is mounted to a carrying structure of the vehicle. When the battery pack is fixed at the bottom of the vehicle, the mechanical connection may be established from the bottom side by for example bolts passing through the carrier framework of the battery pack. The framework is generally made of aluminum or an aluminum alloy to lower the total weight of the construction.

Related art battery system, despite any modular structure, usually include a housing that acts as an enclosure to seal the battery system against the environment and provides structural protection of the battery system's components. Housed battery systems are generally mounted as a whole into their application environment, e.g. an electric vehicle. Thus, the replacement of defective system parts, e.g. a defect battery submodule, requires dismounting the whole battery system and removal of the housing first. Even small defects or the replacement of cheap system parts might require dismounting and replacement of the entire battery system and its separate repair. Because high-capacity battery systems are expensive, large and heavy, such a procedure is burdensome and the storage, such as in the mechanic's workshop, of the bulky battery systems is difficult.

Battery systems generally have voltage sources of hazardous voltage level. Misuse of the battery system or deformations of the housing thereof, e.g. caused by external forces exerted on the underbody of the battery system during collisions or by material fatigue, may lead to dielectric breakdown. Dielectric breakdown can cause fires or even explosions inside of the battery system.

**Summary of Invention**

The invention is defined by the appended claims. The description that follows is subjected to this limitation. Any disclosure lying outside the scope of the claims is only intended for illustrative as well as comparative purposes.

According to one aspect of the present disclosure, a housing for a battery system is provided. The housing includes an underbody structure and a detection system for detecting damages of the underbody structure. The underbody structure includes an upper portion and a lower portion which are electrically conductive and oppositely arranged at a distance from each other to be electrically isolated from each other such that a capacitor is formed. The detection system includes a resonant circuit into which the capacitor is interconnected. The detection system is further configured to apply a voltage to the resonant circuit at the resonance frequency of the resonant circuit and to detect the change of the capacitance by monitoring a change of the current at the resonance frequency.

According to another aspect of the present disclosure, a battery system is provided. The battery system includes the above-mentioned housing and a plurality of battery cells accommodated within the housing.

Yet another aspect of the present disclosure refers to an electric vehicle including the above-mentioned battery system.

Yet another aspect of the present disclosure refers to a method for detecting damages of an underbody structure of a housing for a battery system. According to one step of the method, the above-mentioned housing for a battery system is provided. Further, a voltage is applied to the resonant circuit at the resonance frequency of the resonant circuit and a change of the capacitance is detected by monitoring a change of the current at the resonance frequency. Further aspects of the present disclosure could be learned from the dependent claims or the following description.

**Brief Description of the Drawings**

Features will become apparent to those of ordinary skill in the art by describing in detail exemplary embodiments with reference to the attached drawings in which:

Fig. 1 illustrates a sectional view of a battery system including a housing according to an embodiment,

Fig. 2 illustrates a schematic phase-current-diagram of a resonance circuit,

Fig. 3 illustrates a sectional view of a battery system including a housing according to an embodiment, and

Fig. 4 illustrates a flow diagram of a method according to an embodiment.

**Detailed Description of the invention**

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art.

Accordingly, processes, elements, and techniques that are not considered necessary to those having ordinary skill in the art for a complete understanding of the aspects and features of the present disclosure may not be described. In the drawings, the relative sizes of elements, layers, and regions may be exaggerated for clarity.

Herein, the terms "upper" and "lower" are defined according to the z-axis. For example, the upper portion is positioned at the upper part of the z-axis, whereas the lower portion is positioned at the lower part thereof. In the drawings, the sizes of elements may be exaggerated for clarity. For example, in the drawings, the size or thickness of each element may be arbitrarily shown for illustrative purposes, and thus the embodiments of the present disclosure should not be construed as being limited thereto.

General Concept

According to one aspect of the present disclosure, a housing for a battery system including an underbody structure and a detection system for detecting damages of the underbody structure is provided. The underbody structure includes an upper portion and a lower portion which are electrically conductive and oppositely arranged at a distance from each other to be electrically isolated from each other such that a capacitor is formed. The detection system includes a resonant circuit into which the capacitor is interconnected. The detection system is further configured to apply a voltage to the resonant circuit at the resonance frequency of the resonant circuit and to detect the change of the capacitance by monitoring a change of the current at the resonance frequency. The resonant frequency is defined as the frequency at which the impedance of the circuit is at a minimum.

In other words, damages occurred to the underbody structure can be detected by indirectly measuring the distance (and changes thereof) along the z-axis between the upper portion and the lower portion of the underbody structure of the housing by using a resonant circuit. If the capacity of the capacitor changes due to deformation of the upper portion and/or the lower portion of the underbody structure, the resonant frequency of the circuit changes such that the current flowing at the applied voltage at the (initial) resonance frequency, i.e. the resonance frequency of the circuit before the deformation occurred, drops significantly. The drop of the current at the (initial) resonance frequency is detected and considered as indicative of damages occurred to the underbody structure. The voltage is applied at the (initial) resonance frequency because at the resonance frequency the highest current peaks are provided, thereby facilitating the measurements thereof. In summary, the invention exploits that damages to the underbody structure cause a change of the distance of the capacitor, thereby changing the capacitance of the capacitor and the resonance frequency of the resonant circuit so that the current at the initial or former resonance frequency changes as well. That is, the detected change of the current indicates damages to the underbody structure. Accordingly, the disadvantage of not knowing the condition of the underbody structure of a housing for a battery system can be overcome.

According to one embodiment, the detection system may be configured to determine a degree of damage of the underbody structure based on the detected change of the capacitance. Strictly speaking, the detection system may be configured to determine a degree of damage of the underbody structure based on a detected change of the current at the (initial) resonance frequency during monitoring thereof. Due to the determination of the degree of damage of the underbody structure, different countermeasures may be taken. Accordingly, the detected damage of the underbody structure may be classified into different categories, such as slightly damaged, moderately damaged and seriously damaged, for example.

The detection system may include a memory unit and may be configured to store the degrees of damage of the underbody structure determined over time on the memory unit and to determine an expected remaining service life of the underbody structure based on the stored determined degrees of damage over time. The memory unit may store historical data about different degrees of damage of underbody structures correlated with expected remaining service lives or lifespans. Advantageously, statements can be made about whether and when maintenance of the battery system or the housing for the battery system is necessary in order to prevent dangerous dielectric breakdowns, for example.

Furthermore, the detection system may be configured to generate a warning signal based on the determined degree of damage of the underbody structure exceeding a predetermined damage threshold and/or based on the determined remaining expected service life of the underbody structure dropping below a predetermined service life threshold. For example, the predetermined damage threshold may correspond to a parameter at which the distance between the upper portion and the lower portion of the underbody structure is reduced below 75 percent, or more specifically below 50 percent or below 25 percent of its initial distance. The predetermined service life threshold may correspond to a parameter at which the next maintenance date or inspection date is intended. Accordingly, when the expected remaining service life of the underbody structure is shorter than the time period to the next maintenance date, a warning signal is generated to indicate the severity of the condition of the underbody structure.

Moreover, the detection system may include an interface. The detection system may then be configured to output the determined degree of damage of the underbody structure, the determined remaining expected service life of the underbody structure and/or the generated warning signal via the interface. The interface may be connected to a battery management system (BMS) of the battery system and/or to a control unit of the vehicle. The interface may further be directly or indirectly connected to a display and/or to loudspeakers of the vehicle to inform the driver of the vehicle about the condition of the underbody structure.

According to another embodiment, the housing may further include an underbody protective plate and a cooler plate thermally connectable to battery cells disposed in the housing. The upper portion may form at least a part of the cooler plate of the housing and/or the lower portion may form at least a part of the underbody protective plate. Since housings for battery systems usually include an underbody protective plate and a cooler plate, the detection of the capacitance of the capacitor according to the present disclosure may be performed without requiring additional assembly space.

According to another embodiment, the housing may further include an underbody protective plate and a cooler plate thermally connectable to the battery cells disposed in the housing. The upper portion and the lower portion may be arranged between the underbody protective plate and the cooler plate.

According to another embodiment, the upper portion and/or the lower portion may include a metal foil and/or a metal coating. The metal foil and/or the metal coating may consist of aluminum or an alloy thereof. Aluminum is known for good conductivity, good durability and good availability.

According to another embodiment, the underbody structure may include an air cushion film arranged between the upper portion and the lower portion. For example, the underbody structure may include a double-sided aluminum coating of an air cushion film. That is, the upper portion and the lower portion form the aluminum coatings of the air cushion film. Air cushion films with double-sided aluminum coatings are widely available at low cost.

According to another embodiment, the housing may be sealable and the upper portion and/or the lower portion may form a part of the sealing structure. For example, the upper portion and/or the lower portion may be at least a part of the cooling plate and/or the underbody protective plate forming a part of the sealing structure. Accordingly, a compact design may be achieved.

According to another embodiment, the resonant circuit may include a resistor (R), an inductor (L), and the capacitor (C) forming an RLC-circuit. The three components RLC are all in series or in parallel with the voltage source, i.e. forming a series RLC-circuit or a parallel RLC-circuit. All three elements in series or all three elements in parallel are the simplest in concept and the most straightforward to analyze.

According to another embodiment, the detection system may be further configured to determine a capacitance value of the capacitor and to determine a degree of damage of the underbody structure based on the determined capacitance value. In other words, the capacitance value of the capacitor may be directly measured by the detection system. That is, the damage of the underbody structure is detected redundantly, thereby increasing the reliability of the determined degree of damage of the underbody structure.

Optional features described in view of one aspect of the present disclosure may be interchangeably used for other aspects of the present disclosure. The advantages described with the optional features applies analogously. A recurring description thereof is therefore omitted.

Specific Embodiments

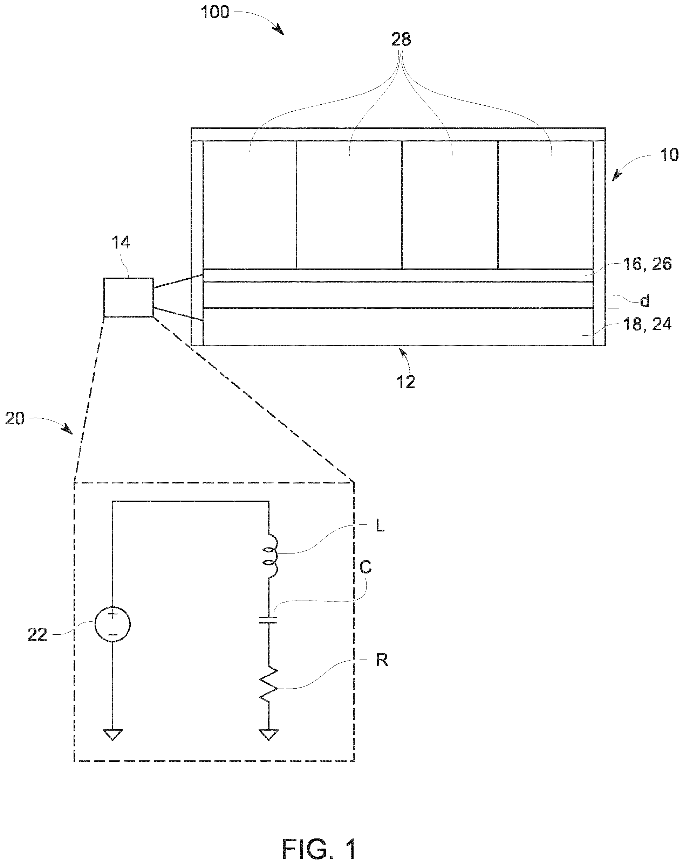

Fig. 1 is a sectional view illustrating a battery system 100 including a housing 10 according to an embodiment.

The housing 10 includes an underbody structure 12 and a detection system 14 for detecting damages of the underbody structure 12. The housing 10 may further include side walls and a top cover such that the underbody structure 12, the side walls and the top cover serve as an enclosure sealing the battery system 100 against the environment and provide structural protection of the components of the battery system 100, e.g. a plurality of battery cells 28 disposed in the housing 10 as shown in Fig. 1. Such housed battery system 100 is generally mounted as a whole into their application environment, e.g. an electric vehicle (not shown). Therefore, the condition of the underbody structure 12 of the housing 10 of the battery system 100 is generally unknown in the mounted state thereof.

The underbody structure 12 include an upper portion 16 and a lower portion 18 which are electrically conductive and oppositely arranged at a distance d from each other to be electrically isolated from each other such that a capacitor C is formed by the upper portion 16 and the lower portion 18. The upper portion 16 and the lower portion 18 are arranged in parallel such that the distance d is substantially constant over the area of the capacitor.

As commonly known, the capacitance of a capacitor is given by the surface area A of the plates, the distance d between the plates, and the permittivity $\epsilon_0 \cdot \epsilon_r$ of the material between the plates, following the equation:

$$C = \epsilon_0 \cdot \epsilon_r \cdot \frac{A}{d}$$

Hence, the capacitance of the capacitor C changes when the distance d between the plates changes. Thus, if the lower portion 18 of the underbody structure 12 is deformed by a misuse of the battery system 100, by external forces exerted thereon during collisions or by general material fatigue, the distance d will change such that the capacitance of the capacitor C will change as well. However, the battery system 100 generally has voltage sources of hazardous voltage level such that a reduction of the distance d may lead to a dielectric breakdown which is critical because it may cause fires or even explosions inside of the battery system 100. Therefore, the present invention provides a solution for overcoming the disadvantage of not knowing the condition of the underbody structure 12 of the housing 10 of the battery system 100.

As shown in the enlarged insert of Fig. 1, the detection system 14 includes a resonant circuit 20 into which the capacitor C, i.e. the upper portion 16 and the lower portion 18 of the underbody structure 12, is interconnected. The resonant circuit 20 further includes a resistor R and an inductor L to form an RLC-circuit. The resistor R, the inductor L and the capacitor C are connected in series, but they are not limited thereto. For example, the resistor R, the inductor L and the capacitor C may alternatively be connected in parallel or an arbitrary combination thereof. An arrangement with all three elements R, L, C in series or in parallel is, however, the simplest in concept and the most straightforward to analyze.

The detection system 14 is configured to apply a voltage to the resonant circuit 20 at the resonance frequency of the resonant circuit 20 and to detect the change of the capacitance of the capacitor C by monitoring a change of the current at the resonance frequency. The current value and its change may be measured by an Ampere meter 22 connected in series as depicted in Fig. 1.

The detection system 14 may be attached to the housing 10, e.g. to one of the side walls or to the underbody structure 12. For example, the detection system 14 may be attached to an inner surface of the housing 10 directed inwards or to an outer surface of the housing 10 directed to the outside. The detection system 14 may include a printed circuit board (PCB) on which the resistor R, the inductor L and the Ampere meter 22 are provided. The PCB is electrically connected to the capacitor C. Furthermore, the housing 10 may include a recess configured to (completely) receive the detection system 14, e.g. the PCB, and the detection system 14 may be received in the recess in a space saving and compact manner.

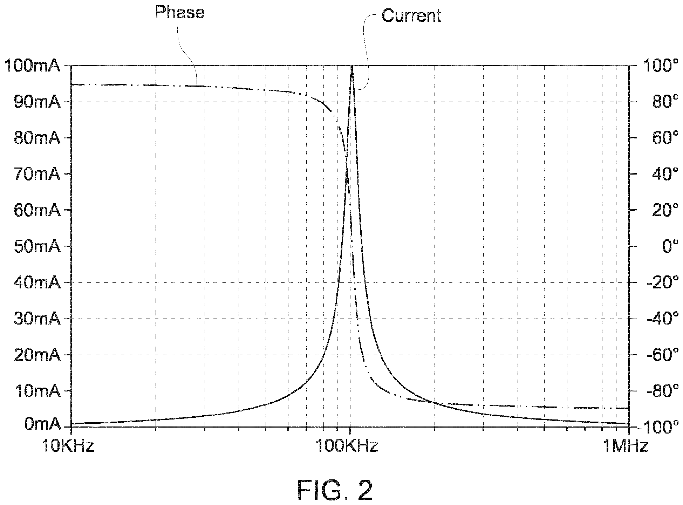

Fig. 2 illustrates a schematic phase-current-diagram over frequency of an exemplary resonance circuit 20 in which the resistor R, the inductor L and the capacitor C are all connected in series with the voltage source (series RLC-circuit). For the sake of better comprehensibility, values of the parameters are shown at the coordinate axes. The resonance frequency is 100 kHz and the maximum current at the resonance frequency is 100 mA. However, these values are merely exemplary and the invention is not limited thereto. It is to be understood, that the resonance frequency of the resonant circuit 20 depends on its particular design and implementation. The diagram of Fig. 2 generally illustrates the behavior of the current in the resonant circuit 20 over voltages applied at different frequencies. When the voltage is applied at the resonance frequency of the resonance circuit 20, the highest current value may be detected.

In the case that the capacity of the capacitor C changes due to deformation of the upper portion 16 and/or the lower portion 18 of the underbody structure 12, the resonant frequency of the resonant circuit 20 changes correspondingly, i.e. the maximum current peak shifts towards higher or lower frequencies, such that the current flowing at the applied voltage at the initial or former resonance frequency, i.e. the resonance frequency of the resonance circuit 20 prior to the deformation, drops significantly. The drop of the current at the initial resonance frequency is detected via the Ampere meter 22 and can be considered as indicative of damages which have occurred to the underbody structure 12. Thus, it is exploited that damages to the underbody structure 12 cause a change of the distance d of the capacitor C, thereby changing the capacitance of the capacitor C and the resonance frequency of the resonant circuit 20 so that the current at the initial or former resonance frequency changes as well. That is, the detected change of the current at the resonance frequency indicates damages to the underbody structure 12.

Fig. 1 further depicts that the housing 10 includes an underbody protective plate 24 and a cooler plate 26 thermally connectable or connected to a plurality of battery cells 28 disposed in the housing 10. According to this embodiment, the upper portion 16 forms the cooler plate 26 of the housing 10 and the lower portion 18 forms the underbody protective plate 24. Thus, the detection of the capacitance of the capacitor C according to this embodiment may be performed without adding a separate capacitor C, thereby saving assembly space.

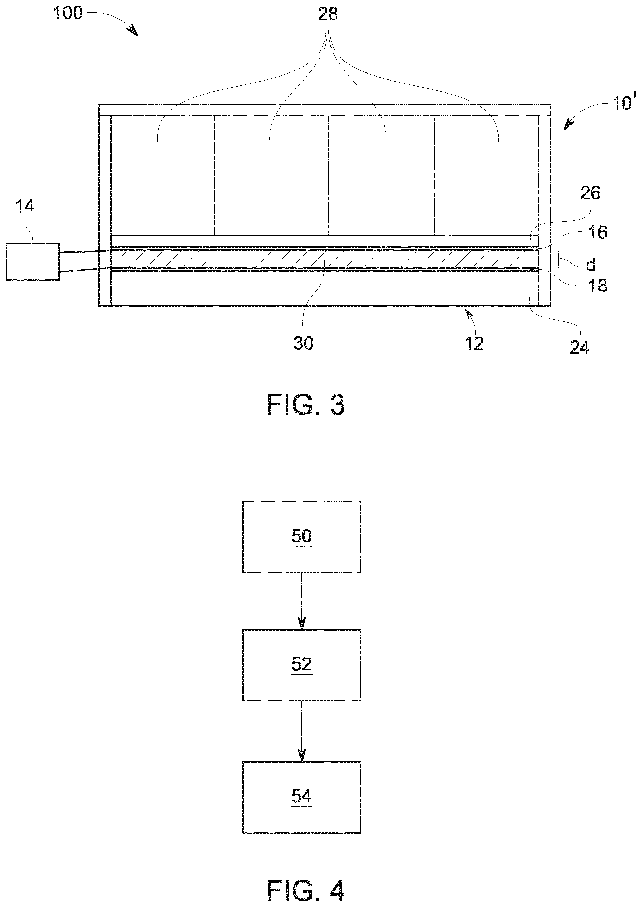

Fig. 3 is a sectional view illustrating a battery system 100 including a housing 10' according to another embodiment. The housing 10' according to this embodiment differs from the housing 10 of Fig. 1 in that the upper portion 16 and the lower portion 18 do not form the cooler plate 26 and the underbody protective plate 24. In other words, the cooler plate 26 and the underbody protective plate 24 are not used to implement the capacitor C in this embodiment. Features described in view of the housing 10 of Fig. 1 may be interchangeably used for the housing 10' of Fig. 3. The advantages described with the features applies analogously. A recurring description thereof is therefore omitted.

According to this embodiment, the upper portion 16 and the lower portion 18 of the underbody structure 12 of the housing 10' are arranged between the underbody protective plate 24 and the cooler plate 26. Thus, the upper portion 16 and the lower portion 18 form a separate capacitor C arranged between the underbody protective plate 24 and the cooler plate 26 and interconnected into the resonant circuit 20 as described in view of Fig. 1. The upper portion 16 and the lower portion 18 of the underbody structure 12 are separated and electrically isolated from the underbody protective plate 24 and the cooler plate 26.

The upper portion 16 and the lower portion 18 according to any of the embodiments described herein may include a metal foil or a metal coating. For example, in view of the embodiment of Fig. 1, the upper portion 16 and the lower portion 18 may be formed as metal foil or metal coating attached to the underbody protective plate 24 and the cooler plate 26 such that the upper portion 16 and the lower portion 18 merely partially form the underbody protective plate 24 and the cooler plate 26. The metal is aluminum or an alloy including aluminum. Aluminum is lightweight and also known for good conductivity, good durability and good availability.

As further shown in Fig. 3, the underbody structure 12 includes an air cushion film 30 arranged between the upper portion 16 and the lower portion 18. The air cushion film 30 provides decent electrical isolation. For example, the underbody structure 12 includes a double-sided aluminum coating of an air cushion film. That is, the upper portion 16 and the lower portion 18 form the aluminum coatings deposited on the air cushion film 30. Such air cushion film with double-sided aluminum coatings is widely available at low cost.

Fig. 4 is a flow diagram illustrating of a method for detecting damages of an underbody structure of a housing for a battery system, namely the above-mentioned underbody structure 12 of the housing 10, 10' for the battery system 100, according to each embodiment. Optional features described in view of the housing 10 of Fig. 1 or the housing 1 0' of Fig. 3 may be interchangeably used for the method. The advantages described with the features applies analogously. A recurring description thereof is therefore omitted.

According to a first step 50, the housing 10, 10' for a battery system 100 of one of the above-mentioned embodiments is provided.

Further, a voltage is applied to the resonant circuit 20 at the resonance frequency of the resonant circuit 20 (second step 52).

According to a third step 54, a change of the capacitance of the capacitor C is detected by monitoring a change of the current at the resonance frequency.

**Reference signs**

| | |
|---|---|
| 10, 10' | housing |
| 12 | underbody structure |
| 14 | detection system |
| 16 | upper portion |
| 18 | lower portion |
| 20 | resonant circuit |
| 22 | Ampere meter |
| 24 | underbody protective plate |
| 26 | cooler plate |
| 28 | battery cells |
| 30 | air cushion film |
| 50 | first method step |
| 52 | second method step |
| 54 | third method step |
| d | distance |
| C | capacitor |
| R | resistor |
| L | inductor |

**Claims**

1. A housing (10, 10') for a battery system (100), comprising:

   an underbody structure (12) and
   a detection system (14) for detecting damages of the underbody structure (12),
   wherein the underbody structure (12) comprises an upper portion (16) and a lower portion (18) which are electrically conductive and oppositely arranged at a distance (d) from each other to be electrically isolated from each other such that a capacitor (C) is formed,
   wherein the detection system (14) comprises a resonant circuit (20) into which the capacitor (C) is interconnected, and
   wherein the detection system (14) is configured to apply a voltage to the resonant circuit (20) at the resonance frequency of the resonant circuit (20) and to detect the change of the capacitance by monitoring a change of the current at the resonance frequency.

2. The housing (10, 10') according to claim 1, wherein the detection system (14) is configured to determine a degree of damage of the underbody structure (12) based on the detected change of the capacitance.

3. The housing (10, 10') according to claim 2, wherein the detection system (14) comprises a memory unit and wherein the detection system (14) is configured to:

   - store the degrees of damage of the underbody structure (12) determined over time on the memory unit and
   - determine an expected remaining service life of the underbody structure (12) based on the stored determined degrees of damage over time.

4. The housing (10, 10') according to claims 2 or 3, wherein the detection system (14) is configured to generate a warning signal based on the determined degree of damage of the underbody structure (12) exceeding a predetermined damage threshold and/or based on the determined remaining expected service life of the underbody structure (12) dropping below a predetermined service life threshold.

5. The housing (10, 10') according to any one of claims 2 to 4, wherein the detection system (14) comprises an interface and wherein the detection system (14) is configured to:

   - output the determined degree of damage of the underbody structure (12) via the interface,
   - output the determined remaining expected service life of the underbody structure (12) via the interface and/or
   - output the generated warning signal via the interface.

6. The housing (10) according to any one of the preceding claims, further comprising an underbody protective plate (24) and a cooler plate (26) thermally connectable to battery cells (28) disposed in the housing (10, 10'),
   wherein the upper portion (16) forms at least a part of the cooler plate (26) of the housing (10, 10') and/or the lower portion (18) forms at least a part of the underbody protective plate (24).

7. The housing (10') according to any one of claims 1 to 5, further comprising an underbody protective plate (24) and a cooler plate (26) thermally connectable to the battery cells (28) disposed in the housing (10'), wherein the upper portion (16) and the lower portion (18) are arranged between the underbody protective plate (24) and the cooler plate (26).

8. The housing (10, 10') according to any one of the preceding claims, wherein the upper portion (16) and/or the lower portion (18) comprise a metal foil and/or a metal coating.

9. The housing (10, 10') according to any one of the preceding claims, wherein the underbody structure (12) comprises an air cushion film (30) arranged between the upper portion (16) and the lower portion (18).

10. The housing (10, 10') according to any one of the preceding claims, wherein the housing (10, 10') is sealable and the upper portion (16) and/or the lower portion (18) form a part of the sealing structure.

11. The housing (10, 10') according to any one of the preceding claims, wherein the resonant circuit (20) comprises a resistor (R), an inductor (L), and the capacitor (C) forming an RLC-circuit.

12. The housing (10, 10') according to any one of the preceding claims, wherein the detection system (14) is further configured to determine a capacitance value of the capacitor (C) and to determine a degree of damage of the underbody structure (12) based on the determined capacitance value.

13. A battery system (100), comprising:

   the housing (10, 10') according to any one of the preceding claims and
   a plurality of battery cells (28) accommodated within the housing (10, 10').

14. An electric vehicle comprising the battery system (100) according to claim 13.

15. A method for detecting damages of an underbody structure (12) of a housing (10, 10') for a battery system (100), wherein the method comprises the steps of:

   - providing (50) the housing (10, 10') for a battery system (100) as defined in any one of the claims 1 to 12;
   - applying (52) a voltage to the resonant circuit (20) at the resonance frequency of the resonant circuit (20) and
   - detecting (54) a change of the capacitance by monitoring a change of the current at the resonance frequency.

FIG. 1

FIG. 2

FIG. 3

FIG. 4

Europäisches
Patentamt

European
Patent Office

Office européen
des brevets

# EUROPEAN SEARCH REPORT

Application Number

EP 23 19 8845

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/162098 A1 (HUNG KE-JEN [TW]) 12 June 2014 (2014-06-12) * paragraphs [0007] - [0009], [0019] - [0031] * * figures 1-3 * | 1-13,15 | INV. H01M10/48 H01M10/42 H01M50/249 H01M10/613 H01M10/625 |
| X | DE 10 2021 107733 A1 (BAYERISCHE MOTOREN WERKE AG [DE]) 29 September 2022 (2022-09-29) * paragraphs [0041] - [0065] * * figure 1 * | 1-5,10, 12-15 | H01M10/6554 H01M50/204 H01M50/224 H01M50/284 H01M50/569 H01M50/572 |
| X | DE 10 2018 221331 A1 (AUDI AG [DE]) 10 June 2020 (2020-06-10) * paragraphs [0027] - [0056] * * figures 3, 4 * | 1,15 | |
| A | US 2015/171485 A1 (RAWLINSON PETER DORE [GB]) 18 June 2015 (2015-06-18) * abstract * * figure 18 * | 1-15 | |

TECHNICAL FIELDS
SEARCHED (IPC)

H01M

The present search report has been drawn up for all claims

| Place of search | Date of completion of the search | Examiner |
|---|---|---|
| Munich | 19 February 2024 | Mercedes González |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 19 8845

This annex lists the patent family members relating to the patent documents cited in the above-mentioned European search report.
The members are as contained in the European Patent Office EDP file on
The European Patent Office is in no way liable for these particulars which are merely given for the purpose of information.

19-02-2024

| Patent document cited in search report | Publication date | Patent family member(s) | | Publication date |
|---|---|---|---|---|
| US 2014162098 A1 | 12-06-2014 | TW | 201424081 A | 16-06-2014 |
| | | US | 2014162098 A1 | 12-06-2014 |
| DE 102021107733 A1 | 29-09-2022 | CN | 117083502 A | 17-11-2023 |
| | | DE | 102021107733 A1 | 29-09-2022 |
| | | WO | 2022199987 A1 | 29-09-2022 |
| DE 102018221331 A1 | 10-06-2020 | NONE | | |
| US 2015171485 A1 | 18-06-2015 | NONE | | |

EPO FORM P0459

For more details about this annex : see Official Journal of the European Patent Office, No. 12/82